# EUROPÄISCHE PATENTSCHRIFT

(11) **EP 2 804 708 B1**
(45) Veröffentlichungstag und Bekanntmachung des Hinweises auf die Patenterteilung: **23.12.2015**
(21) Anmeldenummer: 13707844.0
(22) Anmeldetag: 01.03.2013
(51) Int. Cl.: B22D 11/18, B22D 11/22, B22D 11/06

(54) **MODELLIERUNG EINER GIESSWALZANLAGE**
MODELLING OF A CAST ROLLING DEVICE
MODÉLISATION D'UNE INSTALLATION DE COULÉE EN CONTINU

(30) Priorität: 01.03.2012 EP 12157728
(43) Veröffentlichungstag der Anmeldung: 26.11.2014
(73) Patentinhaber: Siemens Aktiengesellschaft, 80333 München (DE)
(72) Erfinder: DAGNER, Johannes, 91052 Erlangen (DE); MATSCHULLAT, Thomas, 90542 Eckental (DE); WINTER, Günther, 91077 Neunkirchen/Brand (DE)
(86) Internationale Anmeldenummer: PCT/EP2013/054129
(87) Internationale Veröffentlichungsnummer: WO 2013/127982

(56) Entgegenhaltungen:
- WO-A1-01/91943
- DE-A1- 19 508 474
- US-A1- 2003 116 301

## Beschreibung

Die vorliegende Erfindung betrifft ein Ermittlungsverfahren für die Dicke und/oder die Temperatur eines mittels einer Gießeinrichtung gegossenen, eine Bandbreite aufweisenden Metallbandes,
- wobei die Gießeinrichtung einen Kokillenbereich aufweist, in den Metall gegossen wird, das eine Metalltemperatur aufweist, die größer als die Solidustemperatur des Metalls ist,
- wobei die Gießeinrichtung eine Anzahl von den Kokillenbereich jeweils einseitig begrenzenden Umlaufelementen aufweist,
- wobei jedes Umlaufelement Oberflächenelemente aufweist, die sich mit einer jeweiligen Umlaufgeschwindigkeit zyklisch entlang einer jeweiligen Umlaufbahn bewegen,
- wobei
   -- die Oberflächenelemente des jeweiligen Umlaufelements an einem jeweiligen Eintauchpunkt in das im Kokillenbereich befindliche Metall eintauchen,
   -- das Metall während der weiteren Fortbewegung der Oberflächenelemente an den eingetauchten Oberflächehelementen zu einer jeweiligen Strangschale erstarrt,
   -- die Oberflächenelemente an einem Abzugspunkt den Kontakt mit der jeweiligen Strangschale beenden,
   -- das Metallband am Abzugspunkt aus dem Kokillenbereich abgezogen wird und
   -- die Strangschalen Bestandteile des Metallbandes sind,
- wobei die Oberflächenelemente des jeweiligen Umlaufelements
   -- für einen vollständigen Umlauf entlang der jeweiligen Umlaufbahn eine jeweilige Zykluszeit benötigen und
   -- für die Fortbewegung vom jeweiligen Eintauchpunkt zum jeweiligen Abzugspunkt eine jeweilige Kontaktzeit benötigen,
- wobei die Umlaufelemente zusätzlich zu einer durch das im Kokillenbereich befindliche Metall bewirkten Enthalpiezufuhr pro Zeiteinheit eine jeweilige Enthalpiemenge mit ihrer Umgebung austauschen.

Die vorliegende Erfindung betrifft weiterhin ein Computerprogramm, das Maschinencode umfasst, der von einem Rechner unmittelbar abarbeitbar ist und dessen Abarbeitung durch den Rechner bewirkt, dass der Rechner ein derartiges Ermittlungsverfahren ausführt.

Die vorliegende Erfindung betrifft weiterhin einen mit einem derartigen Computerprogramm programmierten Rechner.

Die vorliegende Erfindung betrifft weiterhin eine Gießeinrichtung zum Gießen eines eine Bandbreite aufweisenden Metallbandes,
- wobei die Gießeinrichtung einen Kokillenbereich aufweist, in den Metall gegossen wird, das eine Metalltemperatur aufweist, die größer als die Solidustemperatur des Metalls ist,
- wobei die Gießeinrichtung eine Anzahl von den Kokillenbereich jeweils einseitig begrenzenden Umlaufelementen aufweist,
- wobei jedes Umlaufelement Oberflächenelemente aufweist, die sich mit einer jeweiligen Umlaufgeschwindigkeit zyklisch entlang einer jeweiligen Umlaufbahn bewegen,
- wobei die Oberflächenelemente des jeweiligen Umlaufelements an einem jeweiligen Eintauchpunkt in das im Kokillenbereich befindliche Metall eintauchen und das Metallband an einem Abzugspunkt aus dem Kokillenbereich abgezogen wird,
- wobei der Gießeinrichtung ein derartiger Rechner zugeordnet ist.

Aus der EP 0 736 350 B1 ist eine Zweiwalzen-Gießeinrichtung bekannt, bei der das Profil des gegossenen Bandes erfasst wird und ein lokaler Wärmeflusskoeffizient nachgeführt wird, um das gegossene Profil einem Sollprofil anzunähern. Weiterhin wird anhand des Wärmeflusses durch die Gießwalzen mittels eines Modells die sich ergebende Wölbung ermittelt. Der Wärmefluss durch die Walze wird anhand der die Walze durchströmenden Kühlmittelmenge und deren Temperaturdifferenz ermittelt.

Aus der WO 03/045 607 A2 ist eine Zweiwalzen-Gießeinrichtung bekannt, bei der zur Gefügeeinstellung und zur Beeinflussung des Profils des Metallbandes eine modellgestützte Ermittlung erfolgt.

Beide Ansätze erfordern eine umfangreiche Ausstattung der Gießeinrichtung mit einer Sensorik, die umso störungsanfälliger ist, je näher die Sensorik an dem gießfähigen Metall oder dem noch gießheißen gegossenen Strang angeordnet wird.

Es ist selbstverständlich möglich, die Sensoren weiter entfernt anzuordnen. In diesem Fall steigt jedoch die Totzeit, welche vergeht, bis die Wirkung eines Steuereingriffs von der Sensorik erfasst werden kann.

Aus der US 2003/116 301 A1 ist ein Verfahren zur Modellierung einer Gießwalzanlage bekannt. Insbesondere sollen die Oberflächentemperaturen der Gießwalzen der Gießwalzanlage ermittelt werden. Bei der US 2003/116 301 A1 werden die Temperaturen des Kühlmittels vor und nach dem Kühlen der Gießwalzen sowie die Menge an pro Zeiteinheit verwendetem Kühlmittel erfasst. Aus diesen Werten werden die Oberflächentemperaturen der Gießwalzen ermittelt. Die US 2003/116 301 A1 offenbart somit ein Ermittlungsverfahren für die Dicke und/oder die Temperatur eines mittels einer Gießeinrichtung gegossenen, eine Bandbreite aufweisenden Metallbandes, wobei die Gießeinrichtung einen Kokillenbereich aufweist, in den Metall gegossen wird, das eine Metalltemperatur aufweist, die größer als die Solidustemperatur des Metalls ist. Die Gießeinrichtung weist eine Anzahl von den Kokillenbereich jeweils einseitig begrenzenden Umlaufelementen auf, wobei jedes Umlaufelement Oberflächenelemente aufweist, die sich mit einer jeweiligen Umlaufgeschwindigkeit zyklisch entlang einer jeweiligen Umlaufbahn bewegen, wobei die Oberflächenelemente des jeweiligen Umlaufelements an einem jeweiligen Eintauchpunkt in das im Kokillenbereich befindliche Metall eintauchen, das Metall während der weiteren Fortbewegung der Oberflächenelemente an den eingetauchten Oberflächenelementen zu einer jeweiligen Strangschale erstarrt und die Oberflächenelemente an einem Abzugspunkt den Kontakt mit der jeweiligen Strangschale beenden. Das Metallband wird am Abzugspunkt aus dem Kokillenbereich abgezogen. Die Strangschalen sind Bestandteile des Metallbandes. Die Oberflächenelemente des jeweiligen Umlaufelements benötigen für einen vollständigen Umlauf entlang der jeweiligen Umlaufbahn eine jeweilige Zykluszeit und für die Fortbewegung vom jeweiligen Eintauchpunkt zum jeweiligen Abzugspunkt eine jeweilige Kontaktzeit. Die Umlaufelemente tauschen zusätzlich zu einer durch das im Kokillenbereich befindliche Metall pro Zeiteinheit bewirkten Enthalpiezufuhr pro Zeiteinheit eine jeweilige Enthalpiemenge mit ihrer Umgebung aus. Einem Rechner werden die pro Zeiteinheit in den Kokillenbereich gegossene Menge an Metall und die Metalltemperatur, das Metall als solches spezifizierende Kenngrößen sowie pro Umlaufelement die jeweilige Zykluszeit, die jeweilige Kontaktzeit und die pro Zeiteinheit von dem jeweiligen Umlaufelement mit seiner Umgebung ausgetauschte Enthalpiemenge zugeführt.

Aus der WO 01/91943 A1 ist eine Modellierung einer Stranggießanlage bekannt, die eine Durchlaufkokille aufweist. Die Ausbildung des Gefüges im gegossenen Strang wird rechnergestützt modelliert, wobei die Ausbildung des Gefüges durch spezifische Kühlung dynamisch nachgeführt wird. Die WO 01/ 91943 A1 offenbart damit zwar eine Gießeinrichtung mit einem Kokillenbereich. Auch erfolgt eine Modellierung der Gießeinrichtung. Die Seitenwände der Durchlaufkokille tauschen zusätzlich zu einer durch das im Kokillenbereich befindliche Metall pro Zeiteinheit bewirkten Enthalpiezufuhr pro Zeiteinheit eine jeweilige Enthalpiemenge mit ihrer Umgebung aus. Ein Rechner implementiert ein Gießmodell der Gießeinrichtung.

Die Aufgabe der vorliegenden Erfindung besteht darin, Möglichkeiten zu schaffen, mittels derer die Temperatur und/oder die Dicke des gegossenen Metallbandes ohne nennenswerte Verzögerungen prädizierbar sind, ohne Sensoren zu benötigen, die den rauen Bedingungen - insbesondere den hohen Temperaturen - des Gießbetriebs ausgesetzt sind.

Die Aufgabe wird durch ein Ermittlungsverfahren mit den Merkmalen des Anspruchs 1 gelöst. Vorteilhafte Ausgestaltungen des erfindungsgemäßen Betriebsverfahrens sind Gegenstand der abhängigen Ansprüche 2 bis 11.

Erfindungsgemäß ist vorgesehen, ein Ermittlungsverfahren der eingangs genannten Art dadurch auszugestalten,
- dass einem Rechner
   -- die pro Zeiteinheit in den Kokillenbereich gegossene Menge an Metall und die Metalltemperatur,
   -- das Metall als solches spezifizierende Kenngrößen sowie
   -- pro Umlaufelement die jeweilige Zykluszeit, die jeweilige Kontaktzeit und die pro Zeiteinheit von dem jeweiligen Umlaufelement mit seiner Umgebung ausgetauschte Enthalpiemenge zugeführt werden,
- dass der Rechner ein Gießmodell der Gießeinrichtung implementiert,
- dass das Gießmodell ein Bandbildungsmodell sowie für jedes Umlaufelement ein jeweiliges Umlaufelementmodell und ein jeweiliges metallurgisches Erstarrungsmodell umfasst,
- dass der Rechner mittels des jeweiligen Umlaufelementmodells anhand
   -- der pro Zeiteinheit durch das im Kokillenbereich befindliche Metall bewirkten Enthalpiezufuhr,
   -- der pro Zeiteinheit von dem jeweiligen Umlaufelement mit seiner Umgebung ausgetauschten Enthalpiemenge,
   -- der jeweiligen Zykluszeit und
   -- der jeweiligen Kontaktzeit
      jeweils sich entlang der jeweiligen Umlaufbahn ergebende Temperaturen des jeweiligen Oberflächenelements und eine sich im Bereich des Abzugspunkts an dem jeweiligen Oberflächenelement bildende Umlaufelementform ermittelt,
- dass der Rechner mittels des jeweiligen metallurgischen Erstarrungsmodells anhand
   -- der Metalltemperatur,
   -- der sich entlang der jeweiligen Umlaufbahn ergebenden Temperatur des jeweiligen Oberflächenelements,
   -- der sich im Bereich des Abzugspunkts bildenden jeweiligen Umlaufelementform und
   -- den das Metall als solches spezifizierenden Kenngrößen unter Verwendung eines den Wärmeübergang vom Kokillenbereich in das jeweilige Oberflächenelement modellierenden jeweiligen Wärmeübergangsmodells jeweils
   -- die Temperatur des im Kokillenbereich befindlichen, an das jeweilige Oberflächenelement angrenzenden Metalls und
   -- den Wärmefluss von dem an das jeweilige Oberflächenelement angrenzenden Metall in das jeweilige Oberflächenelement
   -- und daraus in Verbindung mit der Umlaufgeschwindigkeit der Oberflächenelemente die sich am Abzugspunkt bildende jeweilige Strangschalendicke ermittelt,
- dass der Rechner mittels des Bandbildungsmodells anhand der Strangschalendicken und der Umlaufelementformen die Dicke des aus dem Kokillenbereich abgezogenen Metallbandes und/ oder anhand der Temperaturen des im Kokillenbereich befindlichen, an das jeweilige Oberflächenelement angrenzenden Metalls für den Abzugspunkt die dortige Temperatur des Metallbandes ermittelt,
- dass der Rechner die ermittelte Dicke und/oder die ermittelte Temperatur weiter verwertet oder zur weiteren Verwertung zur Verfügung stellt.

In einer bevorzugten Ausgestaltung der vorliegenden Erfindung ist vorgesehen,
- dass das Gießmodell zusätzlich ein Badmodell umfasst,
- dass der Rechner mittels des Badmodells anhand
   -- der Metalltemperatur,
   -- für jedes Umlaufelement der sich entlang der jeweiligen Umlaufbahn ergebenden Temperaturen der jeweiligen Oberflächenelemente,
   -- für jedes Umlaufelement der sich im Bereich des Abzugspunkts bildenden jeweiligen Umlaufelementform, für jeden Umlanfelement der pro Zeiteinheit von dem jeweiligen Umlaufelement mit seiner Umgebung ausgetauschten jeweiligen Enthalpiemenge,
   -- den das Metall als solches spezifizierenden Kenngrößen
   -- in Verbindung mit geometrischen Eigenschaften des Kokillenbereichs
   unter Verwendung des Wärmeübergangsmodells eine mindestens zweidimensional ortsaufgelöste Metalltemperaturverteilung des Metalls als Funktion des Ortes im Kokillenbereich ermittelt und
- dass der Rechner unter Verwendung der ermittelten Metalltemperaturverteilung des Metalls die Temperatur des im Kokillenbereich befindlichen, an das jeweilige Oberflächenelement angrenzenden Metalls ermittelt.

Durch diese Ausgestaltung kann das Temperaturverhalten des im Kokillenbereich befindlichen Metalls besser modelliert werden.

Vorzugsweise ist vorgesehen,
- dass der Rechner im Rahmen des jeweiligen Umlaufelementmodells für das jeweilige Umlaufelement anhand
   -- der pro Zeiteinheit von dem jeweiligen Umlaufelement mit seiner Umgebung ausgetauschten Enthalpiemenge,
   -- der jeweiligen Zykluszeit und
   -- der jeweiligen Kontaktzeit
   eine Umlaufelementtemperaturverteilung als Funktion des Ortes zumindest in Umlaufrichtung und in einer orthogonal zur Oberfläche der Oberflächenelemente verlaufenden Tiefenrichtung ermittelt und
- dass der Rechner die jeweilige Umlaufelementform unter Berücksichtigung der Umlaufelementtemperaturverteilung ermittelt.

Durch diese Vorgehensweise kann die jeweilige Umlaufelementform auf relativ einfache Weise ermittelt werden. Insbesondere ist es möglich, dass der Rechner die jeweilige Umlaufelementform durch Integration der Umlaufelementtemperaturverteilung in der Tiefenrichtung ermittelt.

Das Wärmeübergangsmodell ist vorzugsweise als zumindest in Bandbreitenrichtung ortsaufgelöstes, parametrierbares Wärmeübergangsmodell ausgebildet. In diesem Fall kann nicht nur die mittlere Dicke des Metallbandes, sondern kann dessen Profil ermittelt werden. Dies ist insbesondere deshalb von Vorteil, weil beim späteren Walzen des gegossenen Metallbandes dessen Planheit erhalten bleiben muss und Planheit und Profil nicht unabhängig voneinander beeinflusst werden können.

Vorzugsweise ist vorgesehen,
- dass die tatsächliche Dicke und/oder die tatsächliche Temperatur des aus dem Kokillenbereich abgezogenen Metallbandes erfasst werden und
- dass das Wärmeübergangsmodell anhand eines Vergleichs der erfassten tatsächlichen Dicke und/oder der erfassten tatsächlichen Temperatur mit der ermittelten Dicke und/oder der ermittelten Temperatur adaptiert wird.

Durch diese Vorgehensweise wird das Gießmodell im Lauf der Zeit immer besser an die tatsächlichen Verhältnisse angepasst.

Vorzugsweise ist vorgesehen, dass dem Rechner als Parameter Geometrieparameter der Gießeinrichtung zugeführt werden und dass der Rechner die ihm zugeführten Geometrieparameter bei der Ermittlung der Dicke und/oder der Temperatur des Metallbandes berücksichtigt. Durch diese Vorgehensweise ist das erfindungsgemäße Ermittlungsverfahren besonders flexibel. Der Unterschied zwischen Parametern und Variablen wie beispielsweise der Kontaktzeit oder der Zykluszeit besteht darin, dass Parameter dem Rechner einmal vorgegeben werden und dann unverändert beibehalten werden, während Variablen sich jederzeit im laufenden Betrieb ändern können.

Es ist möglich, das erfindungsgemäße Ermittlungsverfahren als reinen Beobachter zu betreiben. Vorzugsweise ist jedoch vorgesehen,
- dass die ermittelte Dicke und/oder die ermittelte Temperatur mit einer Solldicke und/oder einer Solltemperatur verglichen werden und
- dass anhand des Vergleichs mindestens eine Stellgröße für eine die tatsächliche Dicke und/oder die tatsächliche Temperatur beeinflussende Stelleinrichtung ermittelt wird und die Stelleinrichtung entsprechend der ermittelten Stellgröße angesteuert wird.

Die erfindungsgemäße Aufgabe wird weiterhin durch ein Computerprogramm der eingangs genannten Art gelöst. Das Computerprogramm ist in diesem Fall derart ausgestaltet, dass der Rechner ein Ermittlungsverfahren mit allen Schritten eines erfindungsgemäßen Ermittlungsverfahrens ausführt.

Die Aufgabe wird weiterhin durch einen Rechner gelöst, der mit einem erfindungsgemäßen Computerprogramm programmiert ist.

Die Aufgabe wird weiterhin durch eine Gießeinrichtung der eingangs genannten Art gelöst, bei der der Rechner erfindungsgemäß ausgebildet ist.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die in Verbindung mit den Zeichnungen näher erläutert werden. Hierbei zeigen in schematischer Darstellung:
- FIG 1: eine Zweiwalzen-Gießmaschine von der Seite,
- FIG 2: die Gießmaschine von FIG 1 von oben,
- FIG 3: eine Einwalzen-Gießmaschine von der Seite,
- FIG 4: eine Bandgießmaschine von der Seite,
- FIG 5: eine Modelldarstellung eines Umlaufelements,
- FIG 6: eine Rechenanordnung,
- FIG 7: eine Regelanordnung,
- FIG 8: ein mögliches Umlaufelementmodell,
- FIG 9: eine Modifikation von FIG 1 und
- FIG 10: eine Modifikation von FIG 6.

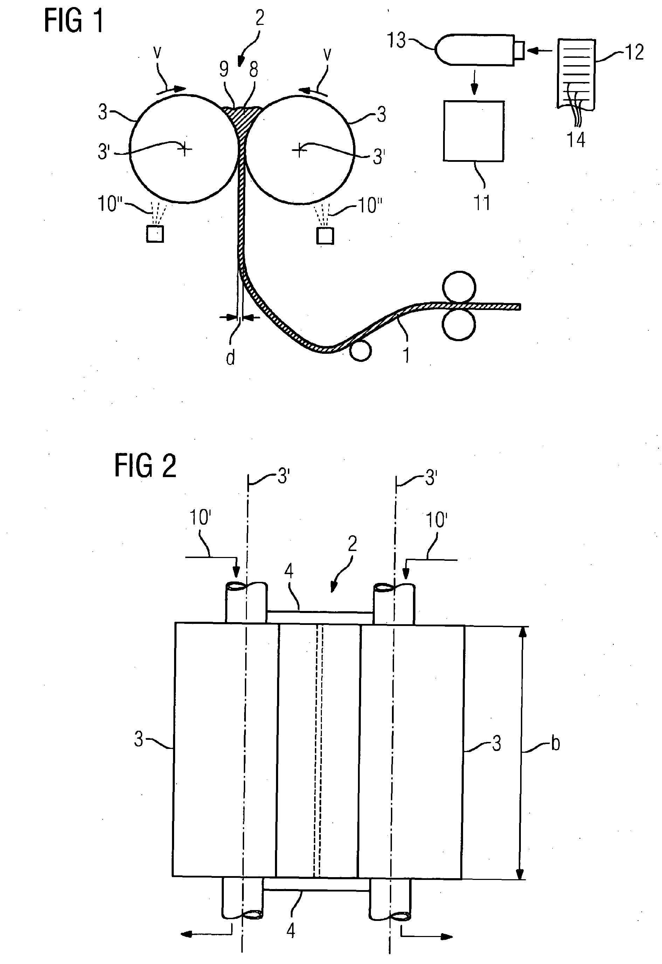

Gemäß den FIG 1 und 2 weist eine Gießeinrichtung zum Gießen eines Metallbandes 1 einen Kokillenbereich 2 auf. Die Gießeinrichtung ist gemäß FIG 1 als Zweiwalzen-Gießmaschine ausgebildet. Sie weist daher zwei im Wesentlichen zylindrische Walzen 3 auf, die gegenläufig zueinander rotieren und den Kokillenbereich 2 an zwei einander gegenüberliegenden Seiten begrenzen. Die beiden weiteren Seiten des Kokillenbereichs 2 sind durch Seitenwände 4 begrenzt.

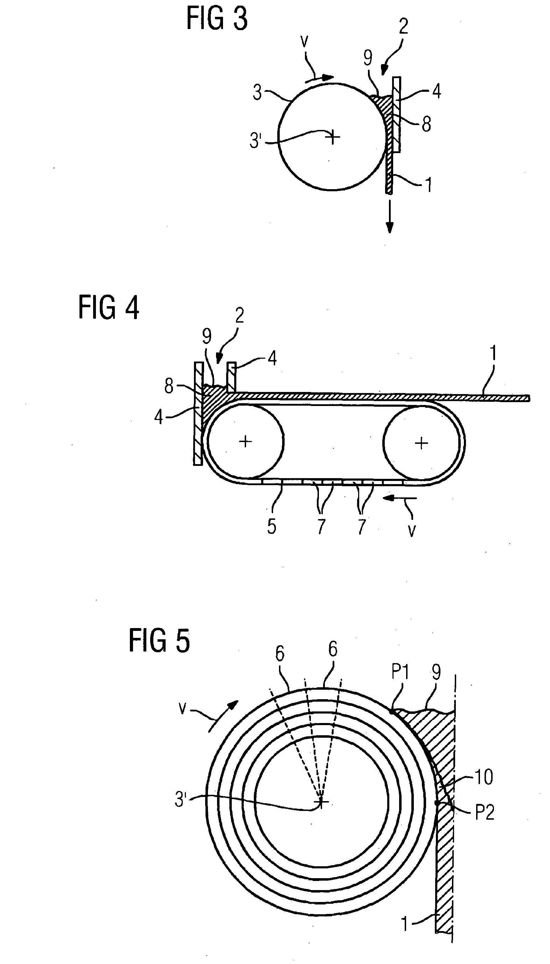

Alternativ könnte die Gießeinrichtung gemäß FIG 3 als Einwalzen-Gießmaschine ausgebildet sein. In diesem Fall weist die Gießmaschine eine einzige Walze 3 auf, die an den Kokillenbereich 2 angrenzt. Die drei anderen Seiten sind in diesem Fall durch die Seitenwände 4 begrenzt.

Die Walzen 3 (bzw. im Falle der Gießmaschine von FIG 3 die einzige Walze 3) entsprechen Umlaufelementen im Sinne der vorliegenden Erfindung. Die Umlaufelemente 3 müssen jedoch nicht zwangsweise walzenförmig ausgebildet sein. Denn alternativ könnte die Gießeinrichtung gemäß FIG 4 als Bandgießmaschine ausgebildet sein. In diesem Fall ist das (einzige) Umlaufelement als umlaufendes Band 5 ausgebildet, nachfolgend zur sprachlichen Unterscheidung vom Metallband 1 als Gießband 5 bezeichnet. Die anderen Seiten des Kokillenbereichs 2 sind bei dieser Ausgestaltung durch die Seitenwände 4 begrenzt.

Unabhängig von der konkreten Konstruktion weist die Gießeinrichtung daher eine Anzahl (nämlich eins oder zwei) von Umlaufelementen 3, 5 auf, wobei jedes Umlaufelement 3, 5 den Kokillenbereich 2 jeweils einseitig begrenzt.

Die Umlaufelemente 3, 5 weisen jeweils eine Anzahl von Oberflächenelementen 6 auf. Im Falle einer Gießwalze (Ausgestaltung gemäß den FIG 1, 2 und 3) sind die Oberflächenelemente 6 gemäß FIG 5 Abschnitte der jeweiligen Gießwalze 3. Im Falle einer Bandgießmaschine sind die Oberflächenelemente 6 die einzelnen Glieder 7 des umlaufenden Bandes 5 (oder Teile der einzelnen Glieder 7). Unabhängig von der konkreten Gestaltung der Gießmaschine bewegen sich die Oberflächenelemente 6 mit einer jeweiligen Umlaufgeschwindigkeit v zyklisch entlang einer jeweiligen Umlaufbahn. Im Falle von Gießwalzen 3 entspricht die jeweilige Umlaufgeschwindigkeit v beispielsweise dem Produkt der Kreisfrequenz und des Radius der jeweiligen Gießwalze 3.

In dem Kokillenbereich 2 wird ein Metall 8 gegossen, das eine Metalltemperatur T aufweist. Bei dem Metall 8 kann es sich beispielsweise um Stahl, Kupfer, Aluminium, Messing oder ein anderes Metall handeln. Unabhängig davon, um welches Metall es sich handelt, liegt die Metalltemperatur T jedoch oberhalb der Solidustemperatur des entsprechenden Metalls 8. Es handelt sich bei dem Metall 8 also entweder um eine reine Schmelze oder um ein Fest-Flüssig-Gemisch.

Das in dem Kokillenbereich 2 gegossene Metall 8 erstreckt sich im Kokillenbereich 2 bis zu einem Gießspiegel 9. Die Oberflächenelemente 6 der Umlaufelemente 3, 5 tauchen an einem jeweiligen Eintauchpunkt P1 in das im Kokillenbereich 2 befindliche Metall 8 ein. Sie bewegen sich sodann innerhalb des Kokillenbereichs 2 weiter bis zu einem Abzugspunkt P2. Während dieser Fortbewegung der Oberflächenelemente 6 entlang des Kokillenbereichs 2 erstarrt das Metall 8 an den eingetauchten Oberflächenelementen 6 zu einer jeweiligen Strangschale 10. Wenn die Oberflächenelemente 6 den Abzugspunkt P2 erreichen, beenden sie den Kontakt mit der jeweiligen Strangschale 10. An diesem Punkt - dem Abzugspunkt P2 - wird das Metallband 1 aus dem Kokillenbereich 2 abgezogen.

Die Strangschalen 10 sind Bestandteile des Metallbandes 1. Im Falle einer Zweiwalzen-Gießmaschine (FIG 1 und 2) sind beide Strangschalen 10 Bestandteile des gegossenen Metallbandes 1. Sie verschweißen am (gemeinsamen) Abzugspunkt P2 oder in dessen Nähe miteinander. Im Falle einer Einwalzengießmaschine (FIG 3) und einer Bandgießmaschine (FIG 4) bildet die einzige Strangschale 10 das Metallband 1.

Die Oberflächenelemente 6 laufen, wie bereits erwähnt, zyklisch entlang einer für das jeweilige Umlaufelement 3, 5 spezifischen Umlaufbahn um. Sie benötigen für einen Umlauf eine jeweilige Zykluszeit t1. Weiterhin benötigen sie für die Fortbewegung vom jeweiligen Eintauchpunkt P1 zum Abzugspunkt P2 eine jeweilige Kontaktzeit t2.

Das Metall 8 ist in der Regel sehr heiß, beispielsweise im Falle von Stahl über 1200° C heiß, meist sogar über 1500° C. Den Umlaufelementen 3, 5 wird daher durch das Gießen des Metalls 8 in den Kokillenbereich 2 eine nennenswerte Enthalpiemenge zugeführt. Diese Enthalpiezufuhr E1 muss durch Kühlung kompensiert werden. In der Regel erfolgt zu diesem Zweck - siehe FIG 2 - durch Ein- und Ausspeisen eines Kühlmediums 10' (beispielsweise Wasser) eine Innenkühlung der Gießwalzen 3 bzw. allgemeiner der Umlaufelemente 3, 5. Weiterhin kann - in Ausnahmefällen alternativ zu einer Innenkühlung, in der Regel jedoch zusätzlich dazu - gemäß FIG 1 eine Außenkühlung der Umlaufelemente 3, 5 erfolgen, beispielsweise mit Wasser oder - bevorzugt - einem inerten kryogenen Kühlmedium 10". Weiterhin strahlen die Umlaufelemente 3, 5 Wärme in ihre Umgebung ab. Schließlich kann es - in ganz besonderen Fällen - möglich sein, die Umlaufelemente 3, 5 von außen zu beheizen.

Unabhängig davon, welche Enthalpiebeeinflussungen gegeben sind, tauschen die Umlaufelemente 3, 5 jedoch zusätzlich zu der eingangs genannten Enthalpiezufuhr E1 durch das im Kokillenbereich 2 befindliche Metall 8 mit ihrer Umgebung pro Zeiteinheit eine jeweilige Enthalpiemenge E2 aus.

Das gegossene Metallband 1 weist eine Bandbreite b auf. Die Bandbreite b ist durch die konstruktive Einstellung der Gießeinrichtung festgelegt. Die Bandbreite b kann während des Gießprozesses nicht verändert werden. Das gegossene Metallband 1 weist weiterhin eine Dicke d auf. Die Dicke d kann beeinflusst werden. Die Dicke d - insbesondere als Funktion über die Bandbreite b und eventuell auch als Funktion über die Bandlänge - stellt eine wichtige Zielgröße des gegossenen Metallbandes 1 dar. In analoger Weise ist auch die Temperatur T' des gegossenen Metallbandes 1 eine wichtige Zielgröße, die beeinflusst werden kann.

Die Dicke d und/oder die Temperatur T' des Metallbandes 1 sollen rechentechnisch ermittelt werden. Zu diesem Zweck ist der Gießeinrichtung ein Rechner 11 zugeordnet. Der Rechner ist mit einem Computerprogramm 12 programmiert. Das Computerprogramm 12 kann dem Rechner 11 beispielsweise über einen mobilen Datenträger 13 zugeführt werden, auf den das Computerprogramm 12 in maschinenlesbarer Form gespeichert ist. Das Computerprogramm 12 umfasst Maschinencode 14, der von dem Rechner 11 unmittelbar abarbeitbar ist. Die Abarbeitung des Maschinencodes 14 durch den Rechner 11 bewirkt, dass der Rechner 11 ein Ermittlungsverfahren für die Temperatur T' und/oder die Dicke d des gegossenen Metallbandes 1 ausführt, das nachfolgend näher erläutert wird.

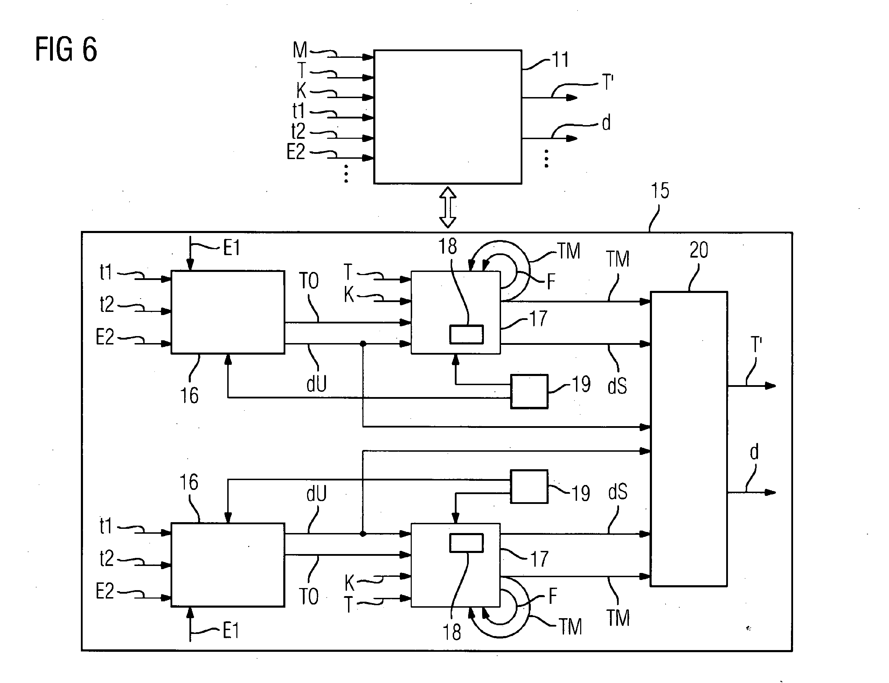

Dem Rechner werden gemäß FIG 6 verschiedene Informationen über das Metall 8 zugeführt. Hierbei handelt es sich um folgende Größen:
- Die Menge M an Metall 8, die pro Zeiteinheit in den Kokillenbereich 2 gegossen wird.
- Die Temperatur T des Metalls 8, also die Metalltemperatur T.
- Kenngrößen K, die das Metall 8 als solches spezifizieren. Die Kenngrößen K können beispielsweise die chemische Zusammensetzung des Metalls 8, die Solidustemperatur, die Dichte, die spezifische Schmelzenthalpie usw. umfassen.

Weiterhin werden dem Rechner 11 bezüglich jedes Umlaufelements 3, 5 Informationen zugeführt. Hierbei handelt es sich pro Umlaufelement 3, 5 um folgende Größen:
- Die Zykluszeit t1,
- die Kontaktzeit t2 und
- die pro Zeiteinheit von dem jeweiligen Umlaufelement 3, 5 mit seiner Umgebung ausgetauschte Enthalpiemenge E2.

Der Rechner 11 implementiert gemäß FIG 6 ein Gießmodell 15 der Gießeinrichtung. Mittels des Gießmodells 15 ermittelt der Rechner 11 die Temperatur T' und/oder die Dicke d des aus dem Kokillenbereich 2 abgezogenen Metallbandes 1.

Das Gießmodell 15 umfasst gemäß FIG 6 für jedes Umlaufelement 3, 5 ein jeweiliges Umlaufelementmodell 16. Die Umlaufelementmodelle 16 für die einzelnen Umlaufelemente 3, 5 können, falls mehrere derartige Modelle 16 vorhanden sind, gleich ausgebildet sein. Sie müssen jedoch in jedem Fall unabhängig voneinander gerechnet und evtl. auch parametriert werden.

Dem jeweiligen Umlaufelementmodell 16 werden folgende, auf das entsprechende Umlaufelement 3, 5 bezogene Größen zugeführt:
- Die pro Zeiteinheit durch das im Kokillenbereich 2 befindliche Metall bewirkte Enthalpiezufuhr E1. Die Enthalpiezufuhr E1 kann der Rechner 11 beispielsweise anhand der Menge M, der Temperatur T und den Kenngrößen K des Metalls 8 ermitteln.
- Die pro Zeiteinheit von dem jeweiligen Umlaufelement 3, 5 mit seiner Umgebung ausgetauschte Enthalpiemenge E2.
- Die jeweilige Zykluszeit t1 und
- die jeweilige Kontaktzeit t2.

Anhand der genannten Größen ermittelt der Rechner 11 mittels des jeweiligen Umlaufelementmodells 16 jeweils die sich entlang der jeweiligen Umlaufbahn ergebenden Temperaturen TO der jeweiligen Oberflächenelemente 6 als Funktion der Zeit bzw. - hiermit korrespondierend - als Funktion des Ortes auf der entsprechenden Umlaufbahn, also entlang der jeweiligen Umlaufbahn. Die Ermittlung der Temperaturen TO erfolgt zumindest für den Abschnitt vom Eintauchpunkt P1 zum Abzugspunkt P2, in der Regel sogar für einen vollständigen Umlauf.

Weiterhin ermittelt der Rechner 11 mittels des jeweiligen Umlaufelementmodells 16 anhand der genannten Größen E2, t1, t2 eine jeweilige Umlaufelementform dU, die sich im entsprechenden Oberflächenelement 6 im Bereich des Abzugspunkt P2 - optimal - am Abzugspunkt P2 selbst - bildet. Der Rechner 11 ermittelt also die thermische Ausdehnung des entsprechenden Umlaufelements 3, 5 im Bereich des Abzugspunkt P2. Falls die Umlaufelementform dU einheitlich über die Bandbreite b ermittelt wird, entspricht sie einer Umlaufelementdicke. Falls die Umlaufelementform in Bandbreitenrichtung ortsaufgelöst ermittelt wird, entspricht sie einem Umlaufelementprofil.

In der Regel verwendet der Rechner 11 im Rahmen des Umlaufelementmodells 16 entsprechend der Darstellung von FIG 6 auch ein jeweiliges Wärmeübergangsmodell 19. Mittels des jeweiligen Wärmeübergangsmodells 19 wird der Wärmeübergang vom Kokillenbereich 2 in das jeweilige Oberflächenelement 6 modelliert.

Die Ausgestaltung des Umlaufelementmodells 16 bzw. der Umlaufelementmodelle 16 kann nach Bedarf sein. Beispielsweise kann das Umlaufelementmodell 16 auf mathematisch-physikalischen Gleichungen basieren, insbesondere auf algebraischen und/oder Differentialgleichungen. Alternativ kann es sich um ein neuronales Netz, ein empirisches Modell und dergleichen mehr handeln. Das Umlaufelementmodell 16 kann in Bandbreitenrichtung ortsaufgelöst sein. Die Ausgestaltung des Umlaufelementmodells 16 ist Fachleuten als solches bekannt.

Das Gießmodell 15 umfasst gemäß FIG 6 weiterhin für jedes Umlaufelement 3, 5 ein jeweiliges metallurgisches Erstarrungsmodell 17. Die metallurgischen Erstarrungsmodelle 17 können - falls mehrere derartige Modelle vorhanden sind - gleich ausgebildet sein. Sie müssen jedoch unabhängig voneinander gerechnet und evtl. auch parametriert werden. Die metallurgischen Erstarrungsmodelle 17 können (optional) zusätzlich ein Gefügemodell 18 umfassen.

Dem jeweiligen metallurgischen Erstarrungsmodell 17 werden zunächst die von dem entsprechenden Umlaufelementmodell 16 ermittelten Größen TO, dU zugeführt, also die Temperaturen TO der entsprechenden Oberflächenelemente 6 entlang der jeweiligen Umlaufbahn und die sich im Bereich des Abzugspunkt P2 bildende Umlaufelementform dU. Weiterhin werden dem jeweiligen metallurgischen Erstarrungsmodell 17 die Metalltemperatur T und die das Metall 8 als solches spezifizierenden Kenngrößen K zugeführt.

Anhand der dem jeweiligen metallurgischen Erstarrungsmodell 17 zugeführten Größen TO, dU, T, K ermittelt der Rechner 11 mittels des jeweiligen metallurgischen Erstarrungsmodells 17 jeweils die Temperatur TM des im Kokillenbereich 2 befindlichen, an das jeweilige Oberflächenelement 6 angrenzenden Metalls 8. Weiterhin ermittelt der Rechner 11 anhand der dem jeweiligen metallurgischen Erstarrungsmodell 17 zugeführten Größen TO, dU, T, K jeweils den Wärmefluss F von dem an das jeweilige Oberflächenelement 6 angrenzenden Metall 8 in das jeweilige Oberflächenelement 6. Bei der Ermittlung der Temperatur TM des an das jeweilige Oberflächenelement 6 angrenzenden Metalls 8 und des Wärmeflusses F von dem Metall 8 in das jeweilige Oberflächenelement 6 verwendet der Rechner 11 gemäß FIG 6 zusätzlich zu den dem jeweiligen metallurgischen Erstarrungsmodell 17 zugeführten Größen TO, dU, T, K das jeweilige Wärmeübergangsmodell 19.

Anhand der ermittelten Temperatur TM des an das jeweilige Oberflächenelement 6 angrenzenden Metalls 8 und des Wärmeflusses F vom Kokillenbereich 2 in das jeweilige Oberflächenelement 6 in Verbindung mit der Umlaufgeschwindigkeit v der Oberflächenelemente 6 kann der Rechner 11 daher im Rahmen des jeweiligen metallurgischen Erstarrungsmodells 17 eine jeweilige Strangschalendicke dS ermitteln, die sich am Abzugspunkt P2 bildet. Weiterhin ist anhand der Temperaturen TM auch die Temperatur TM am Abzugspunkt P2 bekannt.

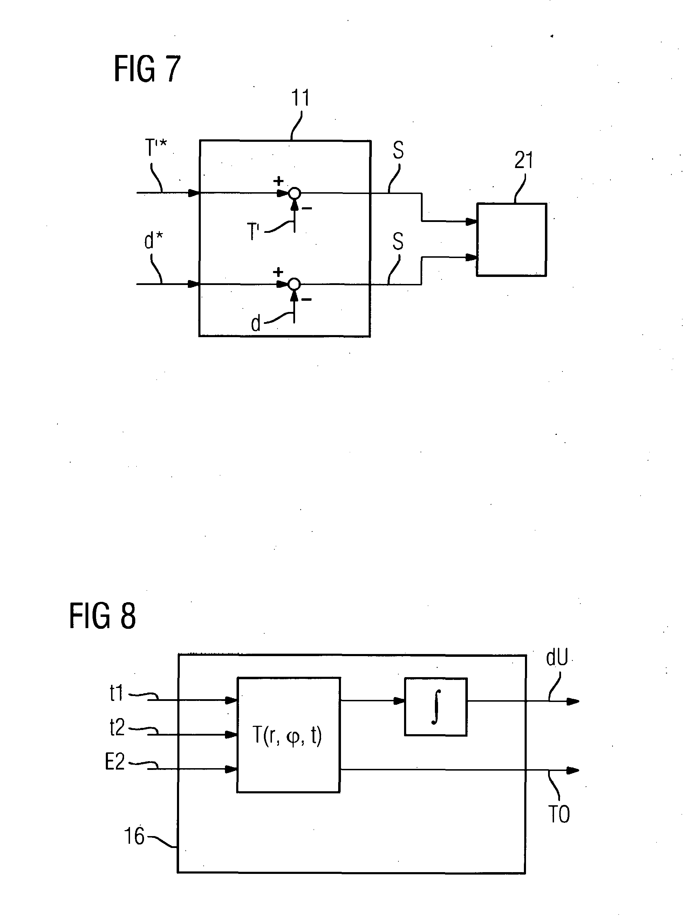

Das Gießmodell 15 umfasst gemäß FIG 6 weiterhin ein Bandbildungsmodell 20. Dem Bandbildungsmodell 20 werden die Temperaturen TM des im Kokillenbereich 2 befindlichen, an die Oberflächenelemente 6 angrenzenden Metalls 8, die Strangschalendicken dS und die Umlaufelementformen dU zugeführt. Mittels des Bandbildungsmodells 20 ermittelt der Rechner 11 die Dicke d und/oder die Temperatur T' des aus dem Kokillenbereich 2 abgezogenen Metallbandes 1. Für die Ermittlung der Dicke d des Metallbandes 1 verwertet der Rechner 11 die Strangschalendicken dS und die Umlaufelementdicken dU. Die Temperatur T' ermittelt der Rechner 11 - beispielsweise durch Mittelwertbildung am Abzugspunkt P2 - anhand der Temperaturen TM. Es ist möglich, dass der Rechner 11 die ermittelte Dicke d und/oder die ermittelte Temperatur T' des Metallbandes 1 zur weiteren Verwertung zur Verfügung stellt. Beispielsweise kann der Rechner 11 entsprechende Ausgaben an einen (nicht dargestellten) Bediener der Gießeinrichtung ausgeben, damit der Bediener geeignete Steuereingriffe vornimmt. Alternativ oder zusätzlich ist es möglich, dass der Rechner 11 die ermittelte Dicke d und/oder die ermittelte Temperatur T' des Metallbandes 1 einer anderen rechentechnischen Einrichtung - beispielsweise einer Steuereinrichtung für die Gießeinrichtung oder einer Steuereinrichtung für eine der Gießeinrichtung nachgeordnete Walzeinrichtung - zur Verfügung stellt. Alternativ oder zusätzlich ist es möglich, dass der Rechner 11 die ermittelte Dicke d und/oder die ermittelte Temperatur T' des Metallbandes 1 selbst weiter verwertet. Insbesondere kann der Rechner 11 beispielsweise selbst als Steuereinrichtung für die Gießeinrichtung ausgebildet sein. In diesem Fall werden die ermittelte Dicke d und/oder die ermittelte Temperatur T' des Metallbandes 1 gemäß FIG 7 mit entsprechenden Sollgrößen d*, T'* verglichen. Anhand des Vergleichs wird mindestens eine Stellgröße S für eine Stelleinrichtung 21 ermittelt. Mittels der Stelleinrichtung 21 können die (tatsächliche) Dicke dE und/oder die (tatsächliche) Temperatur TE des Metallbandes 1 beeinflusst werden. Die Stelleinrichtung 21 wird daher entsprechend der ermittelten Stellgröße S angesteuert.

Falls Sensitivitäten der Stelleinrichtung 21 bekannt sind, falls also bekannt ist, welche Veränderung der Stellgröße S welchen Einfluss auf die Dicke d und/oder die Temperatur T' des Metallbandes 1 hat, kann direkt die Stellgröße S ermittelt werden. Alternativ ist es möglich, die Stellgröße S zu variieren und mittels des Gießmodells 15 erneut zu ermitteln, welche Dicke d und/oder welche Temperatur T' das Metallband 1 dann aufweist. In diesem Fall kann beispielsweise mittels eines deterministischen Algorithmus eine Konvergenz erzwungen werden. Deterministische Algorithmen sind Fachleuten als solche bekannt. Rein beispielhaft werden sogenannte SQP-Algorithmen und genetische Algorithmen genannt.

Die Art der Stelleinrichtung 21 und die Art der Stellgröße S können nach Bedarf bestimmt sein. Beispielsweise können - als global wirkende Stellgröße S die symmetrische und/oder die asymmetrische Anstellung der Gießwalzen 3 voneinander herangezogen werden. Alternativ oder zusätzlich können die Umlaufgeschwindigkeit v und/oder das Ausmaß der Innenkühlung der Gießwalzen 3 eingestellt werden. Alternativ oder zusätzlich können - als global oder lokal wirkende Stellgrößen S eine Außenkühlung und/oder eine Außenheizung, das Einbringen von wärmeleitendem Gas in Vertiefungen der Oberflächenelemente 6, eine mechanische Behandlung der Oberflächenelemente 6 (beispielsweise ein Bürsten) und andere mehr einstellbar sein.

Für die Ermittlung der Umlaufelementform dU sind verschiedene Vorgehensweisen möglich. Beispielsweise ist es gemäß FIG 8 möglich, dass der Rechner 11 im Rahmen des jeweiligen Umlaufelementmodells 16 anhand der pro Zeiteinheit von dem jeweiligen Umlaufelement 3, 5 mit seiner Umgebung ausgetauschten Enthalpiemenge E2, der jeweiligen Zykluszeit t1 und der jeweiligen Kontaktzeit t2 eine innerhalb des jeweiligen Umlaufelements 3, 5 herrschende Temperaturverteilung ermittelt wird, nachfolgend als Umlaufelementtemperaturverteilung bezeichnet. Die Umlaufelementtemperaturverteilung ist in mindestens zwei Variablen ortsaufgelöst, nämlich in Umlaufrichtung und in einer Tiefenrichtung. Die Umlaufrichtung verläuft, wie bereits ihr Name sagt, in Richtung der Bewegung der Oberflächenelemente 6 des jeweiligen Umlaufelements 3, 5. Die Tiefenrichtung verläuft orthogonal zur Oberfläche der Oberflächenelemente 6, also orthogonal zur Umlaufrichtung und orthogonal zur Bandbreitenrichtung. In der Regel ist die Umlaufelementtemperaturverteilung zusätzlich zeitaufgelöst.

Im Falle einer zylindrischen Gießwalze 3 verlaufen die Umlaufrichtung und die Tiefenrichtung tangential (d. h. um die Drehachse 3' der entsprechenden Gießwalze 3 herum) und radial (d. h. auf die Drehachse 3' der Gießwalze 3 zu bzw. von ihr weg). Die Bandbreitenrichtung verläuft - selbstverständlich - axial, also parallel zur Drehachse 3' der entsprechenden Gießwalze 3.

Sodann ermittelt der Rechner 11 die entsprechende Umlaufelementform dU. Im Rahmen der Ermittlung der Umlaufelementform dU berücksichtigt der Rechner 11 die zuvor ermittelte Umlaufelementtemperaturverteilung. Beispielsweise kann der Rechner 11 die jeweilige Umlaufelementform dU durch Integration der Umlaufelementtemperaturverteilung in der Tiefenrichtung ermitteln. Auch andere Vorgehensweisen sind möglich.

Das Wärmeübergangsmodell 19 kann auf verschiedene Art und Weise ausgebildet sein. So ist es beispielsweise möglich, das Wärmeübergangsmodell 19 als einfaches lineares Wärmeübergangsmodell anzusetzen, das den Enthalpiestrom von dem im Kokillenbereich 2 befindlichen Metall 8 in die Oberflächenelemente 6 proportional zur Differenz der Temperaturen TO der entsprechenden Oberflächenelemente 6 und der Temperatur TM des im Kokillenbereich 2 befindlichen Metalls 8 ansetzt, der Wärmeübergangskoeffizient als solcher also eine Konstante ist. Vorzugsweise wird im Rahmen des Wärmeübergangsmodells 19 der Wärmeübergangkoeffizient jedoch als Funktion der jeweiligen Temperatur TO des entsprechenden Oberflächenelements 6 und der Temperatur TM des im Kokillenbereich 2 befindlichen Metalls 8 angesetzt. In beiden Fällen kann das Wärmeübergangsmodell 19 parametrierbar sein. Der Unterschied besteht darin, dass im Falle eines linearen Wärmeübergangsmodells stets ein einziger Koeffizient vorhanden ist, der parametriert wird, und dass im Falle eines nichtlinearen Wärmeübergangsmodells 19 die Anzahl an Koeffizienten größer als 1 sein kann (aber nicht muss).

Weiterhin ist es möglich, dass das Wärmeübergangsmodell 19 in Bandbreitenrichtung gesehen einheitlich ist. Vorzugsweise ist das Wärmeübergangsmodell 19 jedoch in Bandbreitenrichtung ortsaufgelöst. Die Ortsauflösung ist unabhängig davon realisierbar, ob das Wärmeübergangsmodell 19 als lineares oder als nichtlineares Wärmeübergangsmodell 19 realisiert ist. Sie ist auch unabhängig davon, ob und gegebenenfalls in welchem Umfang das Wärmeübergangsmodell 19 parametrierbar ist.

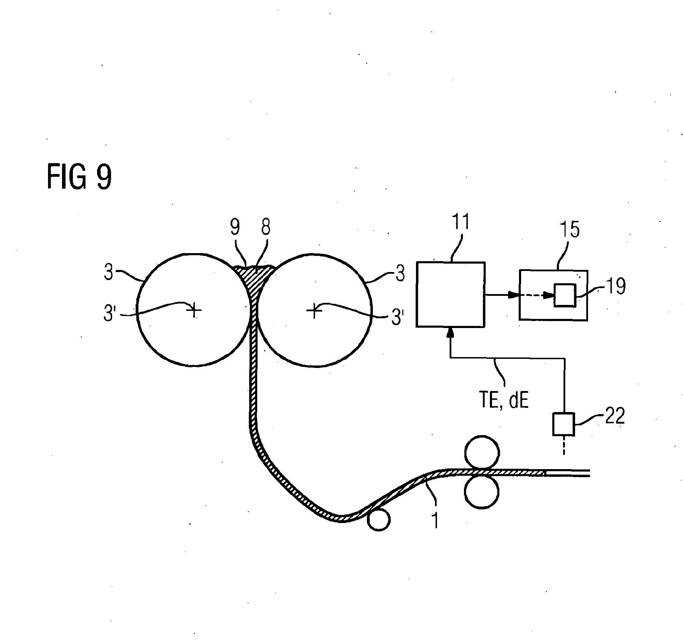

In einer bevorzugten Ausgestaltung der vorliegenden Erfindung - siehe FIG 9 - ist der Gießeinrichtung eine Erfassungseinrichtung 22 nachgeordnet. Mittels der Erfassungseinrichtung 22 werden die tatsächliche Temperatur TE und/oder die tatsächliche Dicke dE des Metallbandes 1 erfasst. Die erfassten Werte dE, TE werden gemäß FIG 9 dem Rechner 11 zugeführt. Der Rechner 11 adaptiert anhand eines Vergleichs der erfassten Dicke dE und/oder der erfassten Temperatur TE des Metallbandes 1 mit der ermittelten Dicke d und/oder der ermittelten Temperatur T' des Metallbandes 1 das Gießmodell 15. Insbesondere kann innerhalb des Gießmodells 15 das Wärmeübergangsmodell 19 adaptiert werden.

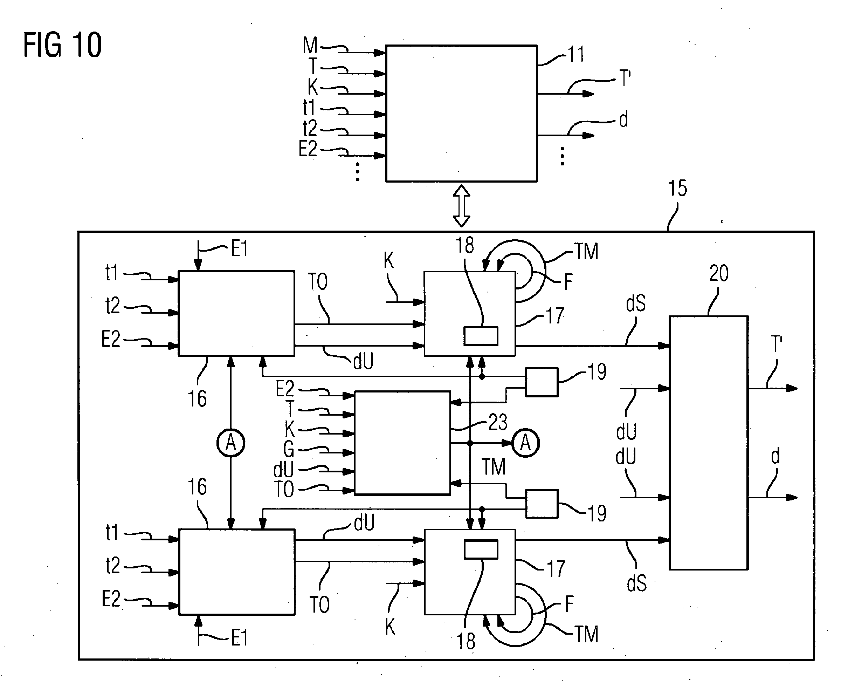

Die Temperatur TM des im Kokillenbereich 2 befindlichen Metalls 8 wird im einfachsten Fall als konstant angenommen. Bereits dieser Ansatz führt zu akzeptablen Ergebnissen. Vorzugsweise umfasst das Gießmodell 15 jedoch gemäß FIG 10 - zusätzlich zu den bereits erwähnten Modellen 16 bis 20 - ein Badmodell 23. Dem Badmodell 23 werden folgende Größen zugeführt:
- Die Metalltemperatur T, d. h. eine skalare Größe, die der Temperatur des Metalls 8 an einer vorbekannten Stelle des Kokillenbereichs 2 entspricht, beispielsweise die Temperatur des in den Kokillenbereich 2 gegossenen Metalls 8.
- Die das Metall 8 als solches spezifizierenden Kenngrößen K.
- Die geometrischen Eigenschaften G des Kokillenbereichs 2. Beispielsweise können dem Badmodell 23 die Durchmesser der Gießwalzen 3 und der Abstand von deren Walzenachsen 3' voneinander zugeführt werden.
- Für jedes Umlaufelement 3, 5 die sich im Bereich des Abzugspunkt P2 bildende jeweilige Umlaufelementform dU.
- Für jedes Umlaufelement 3, 5 die sich entlang der jeweiligen Umlaufbahn ergebenden Temperaturen TO der jeweiligen Oberflächenelemente 6.
- Für jedes Umlaufelement 3, 5 die pro Zeiteinheit von dem jeweiligen Umlaufelement (3, 5) mit seiner Umgebung ausgetauschte jeweilige Enthalpiemenge (E2).

Anhand der vorgegebenen Größen ermittelt der Rechner 11 mittels des Badmodells 23 unter Verwendung des Wärmeübergangsmodells 19 eine mindestens zweidimensional ortsaufgelöste Temperaturverteilung innerhalb des im Kokillenbereich 2 befindlichen Metalls 8, nachfolgend Metalltemperaturverteilung genannt. Die Metalltemperaturverteilung ist also eine Funktion des Ortes im Kokillenbereich 2. Eine der Ortsrichtungen, in denen die Metalltemperaturverteilung ortsaufgelöst ist, ist die Bandbreitenrichtung. Die andere Richtung ist eine höhenabhängige Richtung. Es kann sich beispielsweise um die Lotrechte als solche handeln. Alternativ kann es sich um die - gegebenenfalls ortsabhängige - jeweilige Umlaufelementrichtung handeln. Es ist sogar möglich, die Metalltemperaturverteilung dreidimensional ortsaufgelöst zu ermitteln, also als Volumenverteilung in Bezug auf das im Kokillenbereich 2 befindliche Metall 8. Gegebenenfalls können sogar Verwirbelungen mit modelliert werden.

Wenn der Rechner 11 mittels des Badmodells 23 die Metalltemperaturverteilung ermittelt, ermittelt der Rechner 11 im Rahmen des jeweiligen metallurgischen Erstarrungsmodells 17 die Temperatur TM des im Kokillenbereich 2 befindlichen, an die jeweiligen Oberflächenelemente 6 angrenzenden Metalls 8 unter Verwendung der zuvor ermittelten Metalltemperaturverteilung. Auch für eine Verteilung der Enthalpiezufuhr E1 in Bandbreitenrichtung kann die Temperaturverteilung herangezogen werden.

Es ist möglich, dass dem Rechner 11 die Geometrieparameter G der Gießeinrichtung - beispielsweise die Walzendurchmesser der Gießwalzen 3 und die Bandbreite b - vorab bekannt sind. In der Regel werden die Geometrieparameter G dem Rechner 11 jedoch entsprechend der Darstellung in FIG 10 zugeführt. In jedem Fall berücksichtigt der Rechner 11 die Geometrieparameter jedoch bei der Ermittlung der Dicke d und/oder der Temperatur T' des Metallbandes 1.

Die vorliegende Erfindung kann auf vielfache Weise abgewandelt und ausgestaltet werden. So ist es beispielsweise möglich, die Umlaufelementform dU in Bandbreitenrichtung ortsaufgelöst zu ermitteln. Diese Vorgehensweise ist insbesondere von Vorteil, wenn nicht nur die (mittlere) Dicke des Metallbandes 1 ermittelt werden soll, sondern das Profil des Metallbandes, also die Dicke des Metallbandes 1 als Funktion des Ortes in Bandbreitenrichtung. Analoge Ausführungen gelten für die Temperatur T' des Metallbandes 1.

Weiterhin können die Dicke d und/oder die Temperatur T' oftmals nicht nur global (beispielsweise über die Umlaufgeschwindigkeit v, über die symmetrische oder asymmetrische Anstellung der Gießwalzen 3, über die Innenkühlung und die Höhe des Gießspiegels 9) eingestellt werden. In vielen Fällen sind auch lokale Beeinflussungen der Umlaufelementform dU und auch des Wärmeübergangskoeffizienten möglich. In diesem Fall kann die Modellierung in Bandbreitenrichtung ortsaufgelöst erfolgen und gezielt das Profil des gegossenen Metallbandes 1 eingestellt werden. Beispiele für lokale Beeinflussungen sind obenstehend bereits erwähnt worden. Es handelt sich insbesondere um das Aufbringen eines Kühlmediums 10" von außen auf die Gießwalzen 3, ggf. ein lokales Beheizen sowie ein Bürsten der Umlaufelemente 3, 5 und das lokale Einbringen eines wärmeleitenden inerten Gases (beispielsweise Helium). Die Ortsauflösung in Bandbreitenrichtung kann selbstverständlich auch für andere ermittelte Größen wie beispielsweise die Umlaufelementtemperaturverteilung vorgenommen werden.

Auch die Umlaufelementmodelle 16 können noch weiter ausgestaltet werden. So ist es beispielsweise möglich, mittels des jeweiligen Umlaufelementmodells 16 nicht nur Temperaturänderungen bzw. Wärmeflüsse F, sondern absolute Temperaturen zu ermitteln. In diesem Fall werden also die Wärmeinhalte der Umlaufelemente 3, 5 selbst ermittelt. Dies führt zu einer verbesserten Modellierung der Umlaufelemente 3, 5 und deren Oberflächenelementen 6. Insbesondere ein transientes Verhalten kann dadurch genauer modelliert werden. Weiterhin können die Umlaufelementmodelle 16 die Umlaufelemente 3, 5 vollständig (d. h. in drei Ortsdimensionen) und ggf. auch zusätzlich zeitlich modellieren. Die Umlaufelementmodelle 16 können weiterhin in dem Fall, dass die Umlaufelementform dU in Bandbreitenrichtung ortsaufgelöst ermittelt wird, im Rahmen der Ermittlung auch ein Eigenspannungsverhalten der entsprechenden Umlaufelemente 3, 5 mit berücksichtigen.

Weiterhin ist es möglich, bezüglich des im Kokillenbereich.2 befindlichen Metalls 8 nicht nur zwischen den Phasen fest und flüssig zu unterscheiden, sondern auch die Ausdehnung eines Zweiphasengebietes (sogenannte mushy zone) zu ermitteln. Dies ist insbesondere im Bereich des Abzugspunkts P2 von Bedeutung, da die Größe des Zweiphasengebietes die effektive Strangschalendicke dS und diese wiederum die Dicke d des Metallbandes 1 beeinflusst.

Auch ist es möglich, der Gießeinrichtung nachgeordnete Aggregate in die Modellierung mit einzubeziehen. So kann beispielsweise vorausschauend die Steuerung der Gießeinrichtung derart erfolgen, dass Stellbegrenzungen eines nachgeordneten Walzgerüsts mit berücksichtigt werden.

Die verschiedenen Modelle der vorliegenden Erfindung - also die Umlaufelementmodelle 16, die metallurgischen Erstarrungsmodelle 17, das Bandbildungsmodell 20 sowie ggf. das Gefügemodell 18 und das Badmodell 23 können auf mathematisch-physikalischen Gleichungen basieren. Bei den Gleichungen kann es sich insbesondere um algebraische und/oder Differentialgleichungen handeln. Alternativ kann es sich bei den genannten Modellen um neuronale Netze, empirische Modelle und andere mehr handeln. Die Modelle können, wie bereits erwähnt, in Bandbreitenrichtung ortsaufgelöst sein.

Es ist möglich, das erfindungsgemäße Ermittlungsverfahren online - eventuell sogar in Echtzeit - auszuführen. Alternativ ist es möglich, das erfindungsgemäße Ermittlungsverfahren vorab auszuführen, beispielsweise wenn eine neue Gießpfanne vergossen werden soll oder wenn sich anderweitig Prozessbedingungen ändern, beispielsweise die Menge oder die Temperatur des zugeführten Kühlwassers 10'.

Die vorliegende Erfindung weist viele Vorteile auf. Insbesondere ist eine Instrumentierung mit Sensoren, welche die Walzenbombierung, die Oberflächentemperatur, die Oberflächenraüigkeit usw. erfassen, nicht erforderlich. Auch ist es möglich, Messwerte zu verarbeiten und hierbei Totzeiten zu überbrücken.

Obwohl die Erfindung im Detail durch das bevorzugte Ausführungsbeispiel näher illustriert und beschrieben wurde, so ist die Erfindung nicht durch die offenbarten Beispiele eingeschränkt und andere Varianten können vom Fachmann hieraus abgeleitet werden, ohne den Schutzumfang der Erfindung zu verlassen.

## Patentansprüche

1. Ermittlungsverfahren für die Dicke (d) und/oder die Temperatur (T') eines mittels einer Gießeinrichtung gegossenen, eine Bandbreite (b) aufweisenden Metallbandes (1),
- wobei die Gießeinrichtung einen Kokillenbereich (2) aufweist, in den Metall (8) gegossen wird, das eine Metalltemperatur (T) aufweist, die größer als die Solidustemperatur des Metalls (8) ist,
- wobei die Gießeinrichtung eine Anzahl von den Kokillenbereich (2) jeweils einseitig begrenzenden Umlaufelementen (3, 5) aufweist,
- wobei jedes Umlaufelement (3, 5) Oberflächenelemente (6) aufweist, die sich mit einer jeweiligen Umlaufgeschwindigkeit (v) zyklisch entlang einer jeweiligen Umlaufbahn bewegen,
- wobei
-- die Oberflächenelemente (6) des jeweiligen Umlaufelements (3, 5) an einem jeweiligen Eintauchpunkt (P1) in das im Kokillenbereich (2) befindliche Metall (8) eintauchen,
-- das Metall (8) während der weiteren Fortbewegung der Oberflächenelemente (6) an den eingetauchten Oberflächenelementen (6) zu einer jeweiligen Strangschale (10) erstarrt,
-- die Oberflächenelemente (6) an einem Abzugspunkt (P2) den Kontakt mit der jeweiligen Strangschale (10) beenden,
-- das Metallband (1) am Abzugspunkt (P2) aus dem Kokillenbereich (2) abgezogen wird und
-- die Strangschalen (10) Bestandteile des Metallbandes (1) sind,
- wobei die Oberflächenelemente (6) des jeweiligen Umlaufelements (3, 5)
-- für einen vollständigen Umlauf entlang der jeweiligen Umlaufbahn eine jeweiligen Zykluszeit (t1) benötigen und
-- für die Fortbewegung vom jeweiligen Eintauchpunkt (P1) zum jeweiligen Abzugspunkt (P2) eine jeweilige Kontaktzeit (t2) benötigen,
- wobei die Umlaufelemente (3, 5) zusätzlich zu einer durch das im Kokillenbereich (2) befindliche Metall (8) pro Zeiteinheit bewirkten Enthalpiezufuhr (E1) pro Zeiteinheit eine jeweilige Enthalpiemenge (E2) mit ihrer Umgebung austauschen,
- wobei einem Rechner (11)
-- die pro Zeiteinheit in den Kokillenbereich (1) gegossene Menge (M) an Metall (8) und die Metalltemperatur (T),
-- das Metall (8) als solches spezifizierende Kenngrößen (K) sowie
-- pro Umlaufelement (3, 5) die jeweilige Zykluszeit (t1), die jeweilige Kontaktzeit (t2) und die pro Zeiteinheit von dem jeweiligen Umlaufelement (3, 5) mit seiner Umgebung ausgetauschte Enthalpiemenge (E2) zugeführt werden,
- wobei der Rechner (11) ein Gießmodell (15) der Gießeinrichtung implementiert,
- wobei das Gießmodell (15) ein Bandbildungsmodell (20) sowie für jedes Umlaufelement (3, 5) ein jeweiliges Umlaufelementmodell (16) und ein jeweiliges metallurgisches Erstarrungsmodell (17) umfasst,
- wobei der Rechner (11) mittels des jeweiligen Umlaufelementmodells (16) anhand
-- der pro Zeiteinheit durch das im Kokillenbereich (2) befindliche Metall (8) bewirkten Enthalpiezufuhr (E1),
-- der pro Zeiteinheit von dem jeweiligen Umlaufelement (3, 5) mit seiner Umgebung ausgetauschten Enthalpiemenge (E2),
-- der jeweiligen Zykluszeit (t1) und
-- der jeweiligen Kontaktzeit (t2)
jeweils sich entlang der jeweiligen Umlaufbahn ergebende Temperaturen (TO) des jeweiligen Oberflächenelements (6) und eine sich im Bereich des Abzugspunkts (P2) an dem jeweiligen Oberflächenelement (6) bildende Umlaufelementform (dU) ermittelt,
- wobei der Rechner (11) mittels des jeweiligen metallurgischen Erstarrungsmodells (17) anhand
-- der Metalltemperatur (T),
-- der sich entlang der jeweiligen Umlaufbahn ergebenden Temperaturen (TO) des jeweiligen Oberflächenelements (6),
-- der sich im Bereich des Abzugspunkts (P2) bildenden jeweiligen Umlaufelementform (dU) und
-- den das Metall (8) als solches spezifizierenden Kenngrößen (K)
unter Verwendung eines den Wärmeübergang vom Kokillenbereich (2) in das jeweilige Oberflächenelement (6) modellierenden jeweiligen Wärmeübergangsmodells (19) jeweils
-- die Temperatur (TM) des im Kokillenbereich (2) befindlichen, an das jeweilige Oberflächenelement (6) angrenzenden Metalls (8) und
-- den Wärmefluss (F) von dem an das jeweilige Oberflächenelement (6) angrenzenden Metall (8) in das jeweilige Oberflächenelement (6)
-- und daraus in Verbindung mit der Umlaufgeschwindigkeit (v) der Oberflächenelemente (6) die sich am Abzugspunkt (P2) bildende jeweilige Strangschalendicke (dS) ermittelt,
- wobei der Rechner (11) mittels des Bandbildungsmodells (20) anhand der Strangschalendicken (dS) und der Umlaufelementformen (dU) die Dicke (d) des aus dem Kokillenbereich (2) abgezogenen Metallbandes (1) und/oder anhand der Temperaturen (TM) des im Kokillenbereich (2) befindlichen, an das jeweilige Oberflächenelement (6) angrenzenden Metalls (8) für den Abzugspunkt (P2) die dortige Temperatur (T') des Metallbandes (1) ermittelt,
- wobei der Rechner (11) die ermittelte Dicke (d) und/oder die ermittelte Temperatur (T') weiter verwertet oder zur weiteren Verwertung zur Verfügung stellt.

2. Ermittlungsverfahren nach Anspruch 1,
**dadurch gekennzeichnet,**
- **dass** das Gießmodell (15) zusätzlich ein Badmodell (23) umfasst,
- **dass** der Rechner (11) mittels des Badmodells (23) anhand
-- der Metalltemperatur (T),
-- für jedes Umlaufelement (3, 5) der sich entlang der jeweiligen Umlaufbahn ergebenden Temperaturen (TO) der jeweiligen Oberflächenelemente (6),
-- für jedes Umlaufelement (3, 5) der sich im Bereich des Abzugspunkts (P2) bildenden jeweiligen Umlaufelementform (dU),
-- für jedes Umlaufelement (3, 5) der pro Zeiteinheit von dem jeweiligen Umlaufelement (3, 5) mit seiner Umgebung ausgetauschten jeweiligen Enthalpiemenge (E2),
-- den das Metall (8) als solches spezifizierenden Kenngrößen (K)
-- in Verbindung mit geometrischen Eigenschaften des Kokillenbereichs (2)
unter Verwendung des Wärmeübergangsmodells (19) eine mindestens zweidimensional ortsaufgelöste Metalltemperaturverteilung des Metalls (8) als Funktion des Ortes im Kokillenbereich (2) ermittelt und
- **dass** der Rechner (11) unter Verwendung der ermittelten Metalltemperaturverteilung des Metalls (8) die Temperatur (TM) des im Kokillenbereich (2) befindlichen, an das jeweilige Oberflächenelement (6) angrenzenden Metalls (8) ermittelt.

3. Ermittlungsverfahren nach Anspruch 1 oder 2, **dadurch gekennzeichnet,**
- **dass** der Rechner (11) im Rahmen des jeweiligen Umlaufelementmodells (16) für das jeweilige Umlaufelement (3, 5) anhand
-- der pro Zeiteinheit von dem jeweiligen Umlaufelement (3, 5) mit seiner Umgebung ausgetauschten Enthalpiemenge (E2),
-- der jeweiligen Zykluszeit (t1) und
-- der jeweiligen Kontaktzeit (t2)
eine Umlaufelementtemperaturverteilung als Funktion des Ortes zumindest in Umlaufrichtung und in einer orthogonal zur Oberfläche der Oberflächenelemente (6) verlaufenden Tiefenrichtung ermittelt und
- **dass** der Rechner (11) die jeweilige Umlaufelementform (dU) unter Berücksichtigung der Umlaufelementtemperaturverteilung ermittelt.

4. Ermittlungsverfahren nach Anspruch 3,
**dadurch gekennzeichnet,**
**dass** der Rechner (11) die jeweilige Umlaufelementform (dU) durch Integration der Umlaufelementtemperaturverteilung in der Tiefenrichtung ermittelt.

5. Ermittlungsverfahren nach Anspruch 3 oder 4,
**dadurch gekennzeichnet,**
**dass** der Rechner (11) im Rahmen des jeweiligen Umlaufelementmodells (16) nicht nur Temperaturänderungen oder Wärmeflüsse (F), sondern Wärmeinhalte der Umlaufelemente (3, 5) selbst ermittelt.

6. Ermittlungsverfahren nach einem der obigen Ansprüche,
**dadurch gekennzeichnet,**
**dass** das Wärmeübergangsmodell (19) als zumindest in Bandbreitenrichtung ortsaufgelöstes, parametrierbares Wärmeübergangsmodell (19) ausgebildet ist.

7. Ermittlungsverfahren nach einem der obigen Ansprüche,
**dadurch gekennzeichnet,**
- **dass** die tatsächliche Dicke (dE) und/oder die tatsächliche Temperatur (TE) des aus dem Kokillenbereich (2) abgezogenen Metallbandes (1) erfasst werden und
- **dass** das Wärmeübergangsmodell (19) anhand eines Vergleichs der erfassten tatsächlichen Dicke (dE) und/oder der erfassten tatsächlichen Temperatur (TE) mit der ermittelten Dicke (d) und/oder der ermittelten Temperatur (T') adaptiert wird.

8. Ermittlungsverfahren nach einem der obigen Ansprüche,
**dadurch gekennzeichnet,**
**dass** dem Rechner (11) als Parameter Geometrieparameter (G) der Gießeinrichtung zugeführt werden und dass der Rechner (11) die ihm zugeführten Geometrieparameter (G) bei der Ermittlung der Dicke (d) und/oder der Temperatur (T') des Metallbandes (1) berücksichtigt.

9. Ermittlungsverfahren nach einem der obigen Ansprüche,
**dadurch gekennzeichnet,**
- **dass** die ermittelte Dicke (d) und/oder die ermittelte Temperatur (T') mit einer Solldicke (d*) und/oder einer Solltemperatur (T'*) verglichen werden und
- **dass** anhand des Vergleichs mindestens eine Stellgröße (S) für eine die tatsächliche Dicke (dE) und/oder die tatsächliche Temperatur (TE) beeinflussende Stelleinrichtung (21) ermittelt wird und die Stelleinrichtung (21) entsprechend der ermittelten Stellgröße (S) angesteuert wird.

10. Ermittlungsverfahren nach einem der obigen Ansprüche,
**dadurch gekennzeichnet,**
**dass** der Rechner (11) bezüglich des im Kokillenbereich (2) befindlichen Metalls (8) nicht nur zwischen den Phasen fest und flüssig unterscheidet, sondern auch die Ausdehnung eines Zweiphasengebietes ermittelt.

11. Ermittlungsverfahren nach Anspruch 10,
**dadurch gekennzeichnet,**
**dass** der Rechner (11) die Ausdehnung des Zweiphasengebietes im Rahmen einer Durchbruchsfrüherkennung verwertet.

12. Computerprogramm, das Maschinencode (14) umfasst, der von einem Rechner (11) unmittelbar abarbeitbar ist und dessen Abarbeitung durch den Rechner (11) bewirkt, dass der Rechner (11) ein Ermittlungsverfahren mit allen Schritten eines Ermittlungsverfahrens nach einem der obigen Ansprüche ausführt.

13. Mit einem Computerprogramm (12) nach Anspruch 12 programmierter Rechner (11).

14. Gießeinrichtung zum Gießen eines eine Bandbreite (b) aufweisenden Metallbandes (1),
- wobei die Gießeinrichtung einen Kokillenbereich (2) aufweist, in den Metall (8) gegossen wird, das eine Metalltemperatur (T) aufweist, die größer als die Solidustemperatur des Metalls (8) ist,
- wobei die Gießeinrichtung eine Anzahl von den Kokillenbereich (2) jeweils einseitig begrenzenden Umlaufelementen (3, 5) aufweist,
- wobei jedes Umlaufelement (3, 5) Oberflächenelemente (6) aufweist, die sich mit einer jeweiligen Umlaufgeschwindigkeit (v) zyklisch entlang einer jeweiligen Umlaufbahn bewegen,
- wobei die Oberflächenelemente (6) des jeweiligen Umlaufelements (3, 5) an einem jeweiligen Eintauchpunkt (P1) in das im Kokillenbereich (2) befindliche Metall (8) eintauchen und das Metallband (1) an einem Abzugspunkt (P2) aus dem Kokillenbereich (2) abgezogen wird,
- wobei der Gießeinrichtung ein Rechner (11) nach Anspruch 13 zugeordnet ist.

## Claims

1. Determination method for determining the thickness (d) and/or the temperature (T') of a metal strip (1) cast by means of a casting device and having a strip width (b),
- wherein the casting device has a die region (2) into which is poured metal (8) having a metal temperature (T) that is greater than the solidus temperature of the metal (8),
- wherein the casting device has a number of rotary elements (3, 5) delimiting the die region (2) on one side in each case,
- wherein each rotary element (3, 5) has surface elements (6) which move cyclically along a respective rotation path at a respective rotational speed (v),
- wherein
-- the surface elements (6) of the respective rotary element (3, 5) are immersed at a respective immersion point (P1) into the metal (8) located in the die region (2),
-- during the further onward movement of the surface elements (6) the metal (8) solidifies on the immersed surface elements (6) to form a respective strand shell (10),
-- the surface elements (6) terminate contact with the respective strand shell (10) at a draw-off point (P2),
-- the metal strip (1) is withdrawn from the die region (2) at the draw-off point (P2), and
-- the strand shells (10) are constituent parts of the metal strip (1),
- wherein the surface elements (6) of the respective rotary element (3, 5)
-- require a respective cycle time (t1) for a complete revolution along the respective rotation path and
-- require a respective contact time (t2) for the onward movement from the respective immersion point (P1) to the respective draw-off point (P2),
- wherein in addition to an enthalpy supply (E1) effected per time unit by the metal (8) located in the die region (2) the rotary elements (3, 5) exchange a respective enthalpy quantity (E2) with their environment per time unit,
- wherein a computer (11) is supplied with
-- the quantity (M) of metal (8) poured into the die region (1) per time unit and the metal temperature (T),
-- characteristic values (K) specifying the metal (8) as such, and,
-- per rotary element (3, 5), the respective cycle time (t1), the respective contact time (t2) and the enthalpy quantity (E2) exchanged per time unit by the respective rotary element (3, 5) with its environment,
- wherein the computer (11) implements a casting model (15) of the casting device,
- wherein the casting model (15) comprises a strip formation model (20), as well as a respective rotary element model (16) and a respective metallurgical solidification model (17) for each rotary element (3, 5),
- wherein the computer (11) makes use of the respective rotary element model (16) to determine, on the basis of
-- the enthalpy supply (E1) effected per time unit by the metal (8) located in the die region (2),
-- the enthalpy quantity (E2) exchanged per time unit by the respective rotary element (3, 5) with its environment,
-- the respective cycle time (t1), and
-- the respective contact time (t2),
temperatures (TO) of the respective surface element (6) resulting in each case along the respective rotation path and a rotary element shape (dU) forming on the respective surface element (6) in the vicinity of the draw-off point (P2),
- wherein the computer (11) makes use of the respective metallurgical solidification model (17) to determine, on the basis of
-- the metal temperature (T),
-- the temperatures (TO) of the respective surface element (6) resulting along the respective rotation path,
-- the respective rotary element shape (dU) forming in the vicinity of the draw-off point (P2), and
-- the characteristic values (K) specifying the metal (8) as such,
using a respective heat transfer model (19) modelling the heat transfer from the die region (2) into the respective surface element (6) in each case,
-- the temperature (TM) of the metal (8) located in the die region (2) and adjoining the respective surface element (6), and
-- the heat flow (F) from the metal (8) adjoining the respective surface element (6) into the respective surface element (6),
-- and therefrom, in conjunction with the rotational speed (v) of the surface elements (6), the respective strand shell thickness (dS) forming at the draw-off point (P2),
- wherein the computer (11) makes use of the strip formation model (20) to determine the thickness (d) of the metal strip (1) withdrawn from the die region (2) on the basis of the strand shell thicknesses (dS) and the rotary element shapes (dU) and/or, for the draw-off point (P2), the temperature (T') of the metal strip (1) at that point on the basis of the temperatures (TM) of the metal (8) located in the die region (2) and adjoining the respective surface element (6),
- wherein the computer (11) makes further use of the determined thickness (d) and/or the determined temperature (T') or makes the same available for further evaluation.

2. Determination method according to claim 1,
**characterised in that**
- the casting model (15) additionally includes a bath model (23),
- the computer (11) makes use of the bath model (23) to determine, on the basis of
-- the metal temperature (T),
-- for each rotary element (3, 5), the temperatures (TO) of the respective surface elements (6) resulting along the respective rotation path,
-- for each rotary element (3, 5), the respective rotary element shape (dU) forming in the vicinity of the draw-off point (P2),
-- for each rotary element (3, 5), the respective enthalpy quantity (E2) exchanged per time unit by the respective rotary element (3, 5) with its environment,
-- the characteristic values (K) specifying the metal (8) as such
-- in conjunction with geometric characteristics of the die region (2),
using the heat transfer model (19), an at least two-dimensionally spatially resolved metal temperature distribution of the metal (8) as a function of the location in the die region (2), and
- using the determined metal temperature distribution of the metal (8), the computer (11) determines the temperature (TM) of the metal (8) located in the die region (2) and adjoining the respective surface element (6).

3. Determination method according to claim 1 or 2,
**characterised in that**
- within the scope of the respective rotary element model (16) the computer (11) determines, for the respective rotary element (3, 5), on the basis of
-- the enthalpy quantity (E2) exchanged per time unit by the respective rotary element (3, 5) with its environment,
-- the respective cycle time (t1), and
-- the respective contact time (t2),
a rotary element temperature distribution as a function of the location at least in the rotary direction and in a depth direction extending orthogonally to the surface of the surface elements (6), and
- the computer (11) determines the respective rotary element shape (dU) taking into account the rotary element temperature distribution.

4. Determination method according to claim 3,
**characterised in that**
the computer (11) determines the respective rotary element shape (dU) by integration of the rotary element temperature distribution in the depth direction.

5. Determination method according to claim 3 or 4,
**characterised in that**
within the scope of the respective rotary element model (16) the computer (11) determines not only temperature changes or heat flows (F), but also heat contents of the rotary elements (3, 5) themselves.

6. Determination method according to one of the above claims,
**characterised in that**
the heat transfer model (19) is embodied as a parameterisable heat transfer model (19) that is spatially resolved at least in the strip width direction.

7. Determination method according to one of the above claims,
**characterised in that**
- the actual thickness (dE) and/or the actual temperature (TE) of the metal strip (1) withdrawn from the die region (2) are measured, and
- the heat transfer model (19) is adapted on the basis of a comparison of the measured actual thickness (dE) and/or the measured actual temperature (TE) with the determined thickness (d) and/or the determined temperature (T').

8. Determination method according to one of the above claims,
**characterised in that**
the computer (11) is supplied with geometric parameters (G) of the casting device as parameters and the computer (11) takes the geometric parameters (G) supplied to it into account when determining the thickness (d) and/or the temperature (T') of the metal strip (1).

9. Determination method according to one of the above claims,
**characterised in that**
- the determined thickness (d) and/or the determined temperature (T') are compared with a setpoint thickness (d*) and/or a setpoint temperature (T'*), and
- on the basis of the comparison at least one correcting variable (S) is determined for a final control device (21) influencing the actual thickness (dE) and/or the actual temperature (TE) and the final control device (21) is actuated in accordance with the determined correcting variable (S).

10. Determination method according to one of the above claims,
**characterised in that**
with regard to the metal (8) located in the die region (2) the computer (11) not only differentiates between the solid and liquid phases, but also determines the extent of a two-phase region.

11. Determination method according to claim 10,
**characterised in that**
the computer (11) evaluates the extent of the two-phase region within the scope of early breakout detection.

12. Computer program comprising machine code (14) which can be processed directly by a computer (11) and the processing of which by the computer (11) causes the computer (11) to perform a determination method comprising all the steps of a determination method according to one of the above claims.

13. Computer (11) programmed with a computer program (12) according to claim 12.

14. Casting device for casting a metal strip (1) having a strip width (b),
- wherein the casting device has a die region (2) into which is poured metal (8) having a metal temperature (T) that is greater than the solidus temperature of the metal (8),
- wherein the casting device has a number of rotary elements (3, 5) delimiting the die region (2) on one side in each case,
- wherein each rotary element (3, 5) has surface elements (6) which move cyclically along a respective rotation path at a respective rotational speed (v),
- wherein the surface elements (6) of the respective rotary element (3, 5) are immersed at a respective immersion point (P1) into the metal (8) located in the die region (2) and the metal strip (1) is withdrawn from the die region (2) at a draw-off point (P2), and
- wherein the casting device is assigned a computer (11) according to claim 13.

## Revendications

1. Procédé de détermination de l'épaisseur ( d ) et/ou de la température ( T' ) d'un feuillard ( 1 ) métallique coulé au moyen d'un dispositif de coulée et ayant une largeur ( b ) de feuillard,
- dans lequel le dispositif de coulée a une partie ( 2 ) de lingotière, dans laquelle est coulé du métal d'une température ( T ) de métal qui est plus haute que la température de solidus du métal ( 8 ),
- dans lequel le dispositif de coulée a un certain nombre d'éléments ( 3, 5 ) de circulation délimitant d'un côté respectivement la partie ( 2 ) de lingotière,
- dans lequel chaque élément ( 3, 5 ) de circulation a des éléments ( 6 ) de surface, qui se déplacent cycliquement suivant une orbite de circulation respective à une vitesse ( v ) de circulation respective,
- dans lequel
-- les éléments ( 6 ) de surface de l'élément ( 3,5 ) de circulation respectif plongent en un point ( P1 ) de plongée respectif dans le métal ( 8 ) se trouvant dans la partie ( 2 ) de lingotière,
-- le métal ( 8 ), pendant que se continue le mouvement d'avance des éléments ( 6 ) de surface, se solidifie sur les éléments ( 6 ) de surface immergés en une croûte ( 10 ) de barre de coulée,
-- les éléments ( 6 ) de surface mettent en un point ( P2 ) de retrait fin au contact avec la croûte (10) de barre de coulée,
-- on retire le feuillard ( 1 ) métallique au point ( P2 ) de retrait de la partie ( 2 ) de lingotière et
-- les croûtes ( 10 ) de barre de coulée font partie du feuillard ( 1 ) métallique,
- dans lequel les éléments ( 6 ) de surface de l'élément ( 3, 5 ) de circulation respectif
-- ont besoin, pour une circulation complète suivant l'orbite de circulation respective, d'un temps ( t1 ) de cycle respectif et
-- ont besoin pour la poursuite du déplacement du point ( P1 ) d'immersion respectif vers le point ( P2 ) de retrait respectif d'un temps ( t2 ) de contact respectif,
- les éléments ( 3, 5 ) de circulation échangent avec leur environnement, en plus d'un apport ( E1 ) d'enthalpie provoqué par unité de temps par le métal ( 8 ) se trouvant dans la partie ( 2 ) de lingotière, par unité de temps, une quantité ( E2 ) respective d'enthalpie,
- dans lequel on envoie à un ordinateur ( 11 )
-- la quantité ( M ) de métal ( 8 ), coulée par unité de temps, dans la partie ( 1 ) de lingotière et la température ( T ) du métal,
-- le métal ( 8 ) sous la forme de grandeurs ( K ) caractéristiques le spécifiant ainsi que
-- par élément ( 3, 5 ) de circulation, le temps ( t1 ) de cycle respectif, le temps ( t2 ) de contact respectif et la quantité ( E2 ) d'enthalpie échangée par unité de temps par l'élément ( 3, 5 ) de circulation respectif avec son environnement,
- dans lequel l'ordinateur ( 11 ) met en oeuvre un modèle ( 15 ) de coulée du dispositif de coulée,
- dans lequel le modèle ( 15 ) de coulée comprend un modèle ( 20 ) de formation de feuillard ainsi que, pour chaque élément ( 3, 5 ) de circulation, un modèle ( 16 ) d'élément de circulation respectif et un modèle ( 17 ) de solidification métallurgique respectif,
- dans lequel l'ordinateur ( 11 ) détermine au moyen du modèle ( 16 ) d'élément de circulation respectif à l'aide
-- de l'apport ( E1 ) d'enthalpie provoqué par unité de temps par le métal ( 8 ) se trouvant dans la partie ( 2 ) de lingotière,
-- de la quantité ( E2 ) d'enthalpie échangée avec son environnement par unité de temps par l'élément ( 3, 5 ) de circulation respectif,
-- du temps ( t1 ) de cycle respectif et
-- du temps ( t2 ) de contact respectif
respectivement des températures ( T0 ) se produisant le long de l'orbite de circulation respective de l'élément ( 6 ) de surface respectif et une forme ( dU ) d'élément de circulation se formant dans la partie du point ( P2 ) de retrait sur l'élément ( 6 ) de surface respectif,
- dans lequel l'ordinateur ( 11 ) détermine au moyen du modèle ( 17 ) de solidification métallurgique respectif à l'aide
- de la température ( T ) du métal,
- des températures ( T0 ), se produisant le long de l'orbite de circulation respective, de l'élément ( 6 ) de surface respectif,
- de la forme ( dU ) de l'élément de circulation respectif se formant dans la partie du point ( P2 ) de retrait et
- des grandeurs ( K ) caractéristiques spécifiant le métal ( 8 ) en tant que tel
en utilisant un modèle ( 19 ) de transfert de chaleur respectif modélisant le transfert de chaleur de la partie ( 2 ) de lingotière à l'élément ( 6 ) de surface respectif respectivement
-- la température (TM) du métal ( 8 ) se trouvant dans la partie ( 2 ) de lingotière au voisinage de l'élément ( 6 ) de surface respectif et
-- le flux ( F ) de chaleur allant du métal ( 8 ) voisin de l'élément ( 6 ) de surface respectif à l'élément ( 6 ) de surface respectif
-- et en détermine, en liaison avec la vitesse ( v ) de circulation de l'élément ( 6 ) de surface, l'épaisseur ( dS ) de croûte de barre de coulée respective se formant au point ( P2 ) de retrait,
- dans lequel l'ordinateur ( 11 ) détermine au moyen du modèle ( 20 ) de formation de feuillard, à l'aide des épaisseurs ( dS ) de croûte de barre de coulée et des formes ( dU ) d'éléments de circulation, l'épaisseur ( d ) du feuillard ( 1 ) métallique retiré de la partie ( 2 ) de lingotière et/ou à l'aide des températures ( TM ) du métal ( 8 ) se trouvant dans la partie ( 2 ) de lingotière et voisin de l'élément ( 6 ) de surface respectif pour le point ( P2 ) de retrait, la température ( T' ) en cet endroit du feuillard ( 1 ) métallique,
- dans lequel l'ordinateur ( 11 ) continue à exploiter l'épaisseur ( d ) déterminée et/ou la température ( T' ) déterminée ou les met à disposition pour une exploitation ultérieure.

2. Procédé de détermination suivant la revendication 1, **caractérisé**
- **en ce que** le modèle ( 15 ) de coulée comprend en outre un modèle ( 23 ) de bain,
- **en ce que** l'ordinateur ( 11 ) détermine au moyen du modèle ( 23 ) de coulée à l'aide
-- de la température ( T ) du métal,
-- pour chaque élément ( 3,5 ) de circulation, des températures ( T ), se produisant le long de l'orbite respective, des éléments ( 6 ) de surface respectifs,
-- pour chaque élément ( 3, 5 ) de circulation, la forme ( dU ) d'éléments de circulation respective se formant dans la partie du point ( P2 ) de retrait,
-- pour chaque élément ( 3,5 ) de circulation, la quantité ( E2 ) d'enthalpie respective échangée par unité de temps par l'élément ( 3, 5 ) de circulation respectif avec son environnement,
-- des grandeurs ( K ) caractéristiques spécifiant le métal ( 8 ) en tant que tel,
-- en liaison avec des propriétés géométriques de la partie ( 2 ) de lingotière,
en utilisant le modèle ( 19 ) de transfert de chaleur, une répartition de la température du métal avec résolution dans l'espace en au moins deux dimensions en fonction de l'emplacement dans la partie ( 2 ) de lingotière et
- **en ce que** l'ordinateur ( 11 ) détermine, en utilisant la répartition de température du métal ( 8 ) qui a été déterminée, la température ( TM ) du métal ( 8 ) se trouvant dans la partie ( 2 ) de lingotière et voisin de l'élément ( 6 ) de surface respectif.

3. Procédé de détermination suivant la revendication 1 ou 2, **caractérisé**
- **en ce que** l'ordinateur ( 11 ) détermine, dans le cadre du modèle ( 16 ) respectif de l'élément de circulation, pour l'élément ( 3, 6 ) de circulation respectif à l'aide
-- de la quantité ( E2 ) d'enthalpie échangée par unité de temps par l'élément ( 3, 5 ) de circulation respectif avec son environnement,
-- du temps ( t1 ) de cycle respectif et
-- du temps ( t2 ) de contact respectif
une répartition de température de l'élément de circulation en fonction de l'emplacement au moins dans la direction de circulation et d'une direction en profondeur s'étendant orthogonalement à la surface des éléments ( 6 ) de surface et
- **en ce que** l'ordinateur ( 11 ) détermine la forme ( dU ) de l'élément de circulation respective en prenant en compte la répartition de température de l'élément de circulation.

4. Procédé de détermination suivant la revendication 3,
**caractérisé**
**en ce que** l'ordinateur ( 11 ) détermine la forme ( dU ) de l'élément de circulation respective par intégration de la répartition de température de l'élément de circulation dans la direction en profondeur.

5. Procédé de détermination suivant la revendication 3 ou 4,
**caractérisé**
**en ce que** l'ordinateur ( 11 ) détermine, dans le cadre du modèle ( 16 ) d'élément de circulation respectif, non seulement des variations de température ou des flux ( F ) de chaleur, mais des contenus calorifiques des éléments ( 3, 5 ) de circulation eux-mêmes.

6. Procédé de détermination suivant l'une des revendications précédentes,
**caractérisé**
**en ce que** le modèle ( 19 ) de transfert de chaleur est constitué sous la forme d'un modèle ( 19 ) de transfert de chaleur paramétrable et à résolution dans l'espace au moins dans la direction en largeur du feuillard.

7. Procédé de détermination suivant l'une des revendications précédentes,
**caractérisé**
- **en ce que** l'on détecte l'épaisseur ( dE ) réelle et/ou la température ( TE ) réelle du feuillard ( 1 ) métallique retiré de la partie ( 2 ) de lingotière et
- **en ce que** l'on adapte le modèle ( 19 ) de transfert de chaleur à l'aide d'une comparaison entre l'épaisseur ( dE ) réelle détectée et/ou la température ( TE ) réelle détectée et l'épaisseur ( d ) déterminée et/ou la température ( T' ) déterminée.

8. Procédé de détermination suivant l'une des revendications précédentes,
**caractérisé**
**en ce que** l'on envoie à l'ordinateur ( 11 ) comme paramètre des paramètres ( G ) de géométrie du dispositif de coulée et en ce que l'ordinateur ( 11 ) prend en compte les paramètres ( G ) de géométrie qui lui sont envoyés lorsqu'il détermine l'épaisseur ( d ) et/ou la température ( T' ) du feuillard ( 1 ) de métal.

9. Procédé de détermination suivant l'une des revendications précédentes,
**caractérisé**
- **en ce que** l'on compare l'épaisseur ( d ) déterminée et/ou la température ( T' ) déterminée à une épaisseur ( d* ) de consigne et/ou à une température ( T'* ) de consigne et
- **en ce qu'**à l'aide de la comparaison, on commande au moins une grandeur ( S ) de réglage d'un dispositif ( 21 ) de réglage influençant l'épaisseur ( dE ) réelle et/ou la température ( TE ) réelle et on commande le dispositif ( 21 ) de réglage conformément à la grandeur ( S ) de réglage qui a été déterminée.

10. Procédé de détermination suivant l'une des revendications précédentes,
**caractérisé**
**en ce que** l'ordinateur ( 11 ) distingue, en ce qui concerne le métal ( 8 ) se trouvant dans la partie ( 2 ) de lingotière, non seulement entre les phases solides et liquides, mais détermine également l'étendue d'un domaine à deux phases.

11. Procédé de détermination suivant la revendication 10,
**caractérisé**
**en ce que** l'ordinateur ( 11 ) exploite l'étendue du domaine à deux phases dans le cadre d'une détection précoce d'une rupture.

12. Programme d'ordinateur qui comprend un code ( 14 ) machine, qui peut être exploité directement par un ordinateur ( 11 ) et dont l'exploitation par l'ordinateur ( 11 ) fait que l'ordinateur ( 11 ) exécute un procédé de détermination ayant tous les stades d'un procédé de détermination suivant l'une des revendications précédentes.

13. Ordinateur ( 11 ) programmé par un programme ( 12 ) d'ordinateur suivant la revendication 12.

14. Dispositif de coulée d'un feuillard ( 1 ) métallique ayant une largeur ( b ) de feuillard,
- dans lequel le dispositif de coulée a une partie ( 2 ) de lingotière dans laquelle est coulé du métal ( 8 ), d'une température ( T ) de métal qui est plus haute que la température de solidus du métal ( 8 ),
- dans lequel le dispositif de coulée a un certain nombre d'éléments ( 3, 5 ) de circulation délimitant d'un côté respectivement la partie ( 2 ) de lingotière,
- dans lequel chaque élément ( 3, 5 ) de circulation a des éléments ( 6 ) de surface, qui se déplacent cycliquement suivant une orbite de circulation respective à une vitesse ( v ) de circulation respective,
- dans lequel les éléments ( 6 ) de surface de l'élément ( 3, 5 ) de circulation respectif plongent en un point ( P1 ) d'immersion respectif dans le métal ( 8 ) se trouvant dans la partie ( 2 ) de lingotière et le feuillard ( 1 ) de métal est retiré de la partie ( 2 ) de lingotière en un point ( P2 ) de retrait,
- dans lequel un ordinateur ( 11 ) suivant la revendication 13 est associé au dispositif de coulée.
